# EUROPEAN PATENT APPLICATION

(11) **EP 3 936 245 A1**
(43) Date of publication of application: **12.01.2022**
(21) Application number: 19918476.3
(22) Date of filing: 06.03.2019
(51) Int. Cl.: B09B 3/00, B09B 5/00, H01L 31/048

(54) **RECYCLING APPARATUS FOR SOLAR CELL MODULE**

(71) Applicant: NPC Incorporated, Taito-ku Tokyo 110-0015 (JP)
(72) Inventor: MATSUMOTO, Kenji, Matsuyama-shi, Ehime 791-8044 (JP); TAKIMOTO, Yukio, Matsuyama-shi, Ehime 791-8044 (JP); YAUCHI, Toshiyuki, Matsuyama-shi, Ehime 791-8044 (JP)
(74) Representative: Noble, Nicholas
(86) International application number: PCT/JP2019/008801
(87) International publication number: WO 2020/179002

(57) **Abstract**

To provide a recycling apparatus for a solar cell module capable of peeling off and separating a glass substrate which has been accidentally broken reliably and readily from another material. It includes: a pressing and fixing unit 10 that has a pressing and fixing jig 11 and a conveying unit 20 including a slide surface plate 22 and that pushes and conveys a solar cell module 100 so as to slide on the slide surface plate to a downstream side in a state of pressing, fixing and holding it with the pressing and fixing jig; a cutter unit 30 that, with respect to the held solar cell module, separates a glass substrate 101 and another material from each other using a cutting tool; a downstream pushing-out and carrying-out unit 40 that, given the separated glass substrate, conveys it to the downstream side; and a controlling unit 60 that controls operation of each means, wherein the pressing and fixing jig has a pressing and fixing jig base board 12 that moves upward and downward with an upward and downward motion mechanism, and a module end face abutting member 16, and presses, fixes and holds a surface of the solar cell module on the slide surface plate with the pressing and fixing jig base board in a state of bringing an upstream-side end face of the solar cell module into contact with itself with the module end face abutting member, thereby making it possible to peel off and separate the glass substrate from the other material even in a state where it is broken.

## Description

### BACKGROUND OF THE INVENTION

### FIELD OF THE INVENTION

The present invention relates to a recycling apparatus for a solar cell module.

### RELATED ART

In order to reuse constituent materials (a glass substrate, a sealing agent, solar cells, line materials, back sheet and the like) of a used solar cell module, it is required to separate the individual materials from one another. A recycling apparatus is used when separating, from the glass substrate, the other materials including the solar cells.

There has been a conventional recycling apparatus, disclosed in Patent Document 1, which heats and softens a sealing agent and brings a heated blade into contact between the glass substrate which cracks are given along with the solar cells in a crushing step and the other materials to separate those from each other.

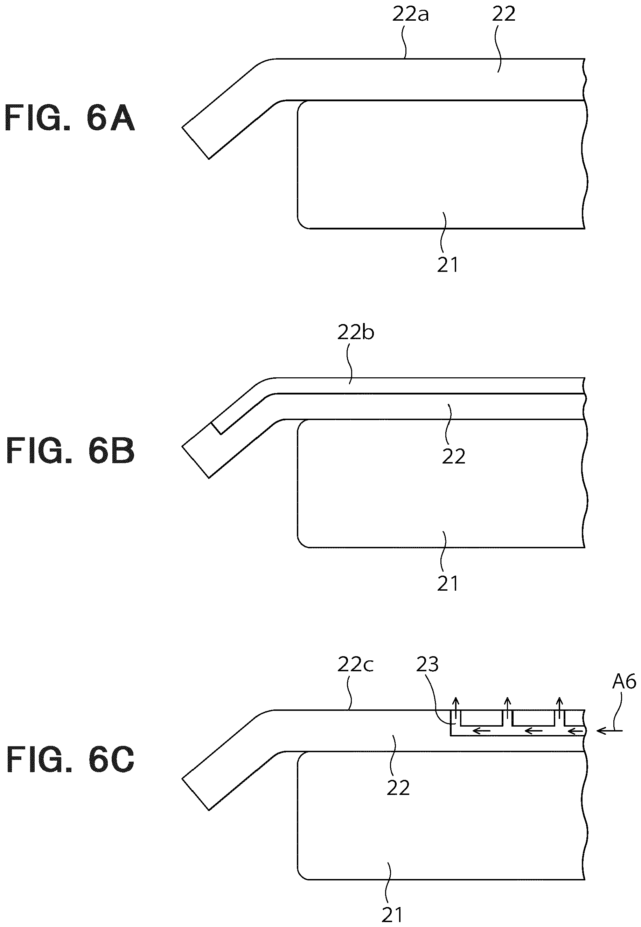

However, Patent Document 1 does not disclose a conveying mechanism of the module or operation of the blade in detail even in Fig. 6 and the like appended therein. This causes any mechanism to be unclear which reliably brings the blade into contact between the glass substrate and the other materials to separate it from the others, and there has been room for improvement.

There are therefore proposed, in Patent Documents 2 and 3 applied by the inventor(s) of the present application, recycling apparatuses for a solar cell module capable of responding also to a warp of the solar cell module and the like to bring the blade into contact between the glass substrate and the other materials without breaking it and allowing peeling-off efficiently in a short time.
Patent Document 1: Japanese Patent No. 5574750
Patent Document 2: Japanese Patent Laid-Open No. 2016-203061
Patent Document 3: Japanese Patent Application No. 2016-229382

However, there has been considered, for the recycling apparatuses disclosed in Patent Documents 2 and 3, a case where when recycling a solar cell module in which the glass substrate is accidentally broken at a site of solar cell power generation or the similar site before carrying-in, peeling-off and separation work between the broken glass substrate and the other materials is not easy.

### SUMMARY OF THE INVENTION

In view of the aforementioned circumstances, an object of the present invention is to provide, as to the recycling apparatuses for a solar cell module proposed in Patent Documents 2 and 3, a recycling apparatus for a solar cell module in which peeling-off and separation between a broken glass substrate and another material are addressed and performed reliably and readily.

The present invention is characterized in providing a recycling apparatus for a solar cell module that separates a glass substrate and another material in a solar cell module from each other, the apparatus including:
a pressing and fixing unit that has a pressing and fixing jig and a conveying unit including a slide surface plate and that, given the solar cell module, pushes and conveys the solar cell module so as to slide on the slide surface plate to a downstream side by moving the pressing and fixing jig to the downstream side in a state of pressing, fixing and holding the solar cell module on the slide surface plate with the pressing and fixing jig;
a cutter unit that, with respect to the solar cell module having been conveyed by the pressing and fixing unit, separates the glass substrate and the other material from each other using a cutting tool;
a downstream pushing-out and carrying-out unit that, given the other material and the separated glass substrate, conveys them to the downstream side in a state of pressing, fixing and holding them with the pressing and fixing jig; and
a controlling unit that controls individual operations of the pressing and fixing unit, the cutter unit and the downstream pushing-out and carrying-out unit, wherein
the pressing and fixing jig has a pressing and fixing jig base board that moves upward and downward with an upward and downward drive mechanism, and a module end face abutting member, and presses, fixes and holds a surface of the solar cell module on the slide surface plate with the pressing and fixing jig base board in a state of bringing an upstream-side end face of the solar cell module into contact with itself with the module end face abutting member.

The recycling apparatus for a solar cell module of the present invention makes it possible to perform peeling-off and separation between the glass substrate and the other material reliably and readily even when the glass substrate is broken before carrying-in.

### BRIEF DESCRIPTION OF THE DRAWINGS

Fig. 1 is a vertical sectional view showing a configuration of a solar cell module.
Fig. 2 is an elevational view showing a schematic configuration of a recycling apparatus for a solar cell module according to an embodiment of the present invention.
Fig. 3 is a lateral view showing a configuration of the recycling apparatus for a solar cell module as viewed from the upstream side.
Fig. 4 is an elevational and enlarged view having a portion of the upstream side of the recycling apparatus for a solar cell module shown in Fig. 1.
Fig. 5 shows enlarged views of the portion of B in Fig. 4 showing configurations of a pressing and fixing jig in the recycling apparatus for a solar cell module.
Fig. 6 shows enlarged views of the portion of B in Fig. 4 showing configurations of upstream-side and downstream-side slide surface plates in the recycling apparatus for a solar cell module.
Fig. 7 is an elevational view showing an arrangement of a blade in a cutter unit in the recycling apparatus for a solar cell module.
Fig. 8 is an elevational view showing positional relations between the blade in the cutter unit, the solar cell module, the slide base boards and the slide surface plates.
Fig. 9 shows plan views each showing an example of the edge shape of the blade in the cutter unit.

### DETAILED DESCRIPTION OF THE EMBODIMENTS

Hereafter, a recycling apparatus for a solar cell module according to an embodiment of the present invention is described in detail with reference to the drawings.

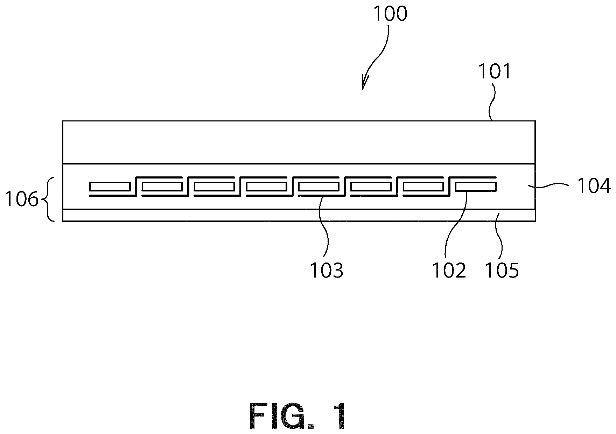

Referring to Fig. 1, there is described an exemplary schematic configuration of a solar cell module 100 which is a target for recycling in the present invention.

The solar cell module 100 has a configuration in which a plurality of solar cells 102 are sealed with a sealing agent 104 in the state where they are connected with line materials 103 between a glass substrate 101 and a back sheet 105.

On this solar cell module 100, the glass substrate 101 and a cell matrix 106 which corresponds to another material are separated from each other.

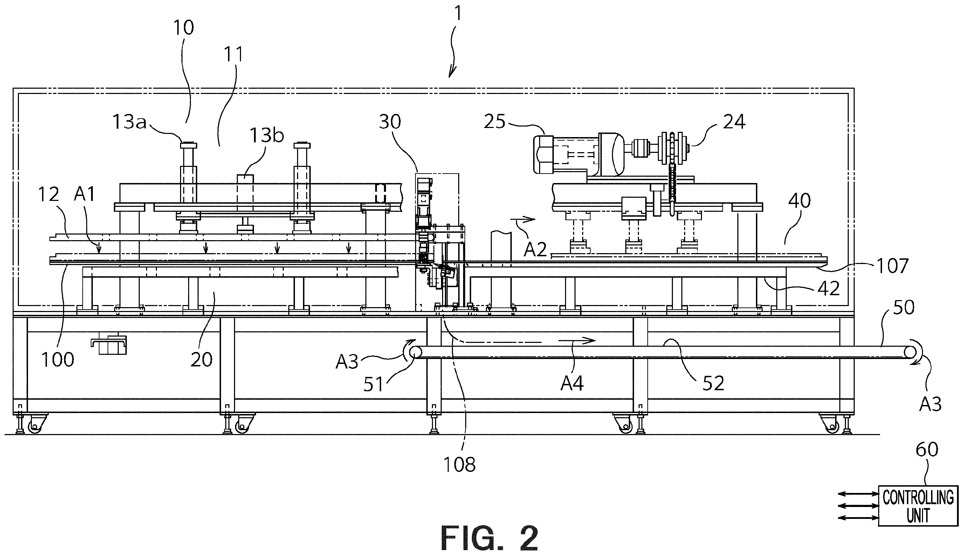

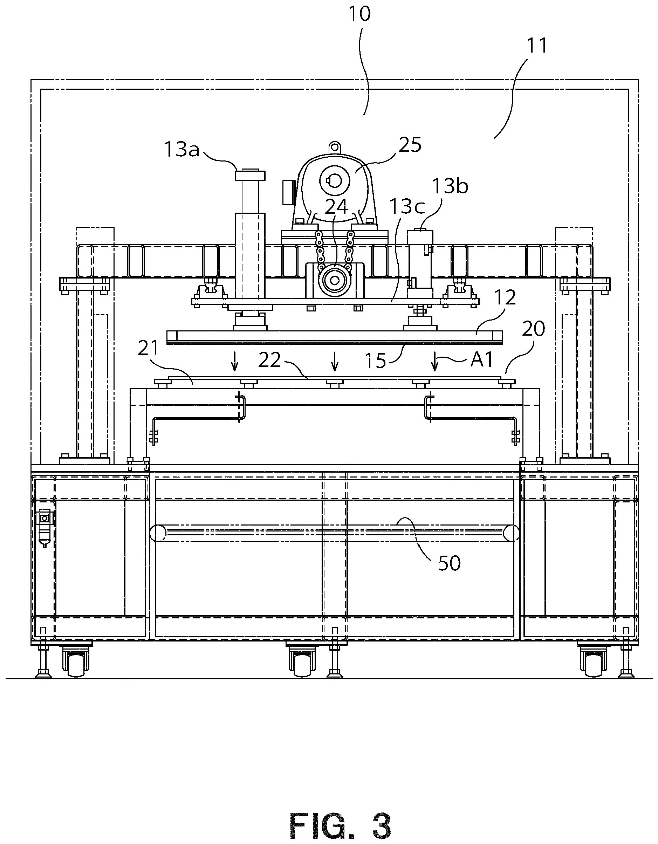

A schematic configuration of a recycling apparatus 1 for a solar cell module according to the present embodiment is described using Fig. 2 which is an elevational view thereof, and Fig. 3 corresponding to a lateral view thereof as viewed from the upstream side in Fig. 2.

This recycling apparatus 1 for a solar cell module includes, as its main components, a pressing and fixing unit 10, a cutter unit 30, a downstream pushing-out and carrying-out unit 40, a carrier 50 and a controlling unit 60.

The pressing and fixing unit 10 has a pressing and fixing jig 11 and a conveying unit 20.

The pressing and fixing jig 11 has a pressing and fixing jig base board 12, guide shafts 13a, upward and downward drive mechanism devices 13b such as motor driven screw shafts and (hydraulically and pneumatically driven) cylinders, and a holding plate 13c, and as mentioned later, a jig abutting base board 15 and a module end face abutting member 16 as well. The pressing and fixing jig 11 moves in the downward direction denoted by arrows A1 toward the solar cell module 100 carried in to a predetermined position from the upstream on the left side in the figure, and holds the solar cell module 100 in the state of pressing and fixing it onto the surface of an upstream-side slide surface plate 22 mentioned later.

The conveying unit 20 has a slide base board 21, the slide surface plate 22, a screw shaft 24 for jig pushing and moving, and a motor 25. The solar cell module 100 pressed and fixed on the surface of the slide surface plate 22 by the pressing and fixing jig 11 is pushed so as to slide on the surface of the slide surface plate 22 in the downstream-side direction denoted by an arrow A2 to be carried toward the cutter unit 30, by the motor 25 rotating and driving the screw shaft 24 for jig pushing and moving which the pressing and fixing jig 11 is attached to, and is carried from the cutter unit 30 toward the downstream pushing-out and carrying-out unit 40.

As mentioned later, the cutter unit 30 has a blade 31, a heater 32 which is built in the blade 31 and heats the portion of a cutting-into blade at the edge of the blade 31, and a buffer mechanism 33 which provides a buffer function to the blade 31. The blade 31 heated by the heater 32 separates the solar cell module 100 into the glass substrate 101, and the cell matrix 106 as another portion.

The downstream pushing-out and carrying-out unit 40 has a slide surface plate 43 as mentioned later on the surface of a slide base board 42, and pushes and carries only a glass substrate 107 thus separated in the state of fixing and holding it onto the surface of the slide surface plate 43 with the pressing and fixing jig 11 such that it slides on the surface of the slide surface plate 43 toward the further downstream side.

The carrier 50 has rollers 51, a conveying belt 52, and a not-shown motor and moves the conveying belt 52, with the motor, in the direction of an arrow A4 with the rollers 51 rotating with the motor in the direction of an arrow A3 to carry a cell matrix sheet 108 thus separated on the conveying belt 52.

The controlling unit 60 controls individual operations of the pressing and fixing unit 10, the cutter unit 30, the downstream pushing-out and carrying-out unit 40 and the carrier 50.

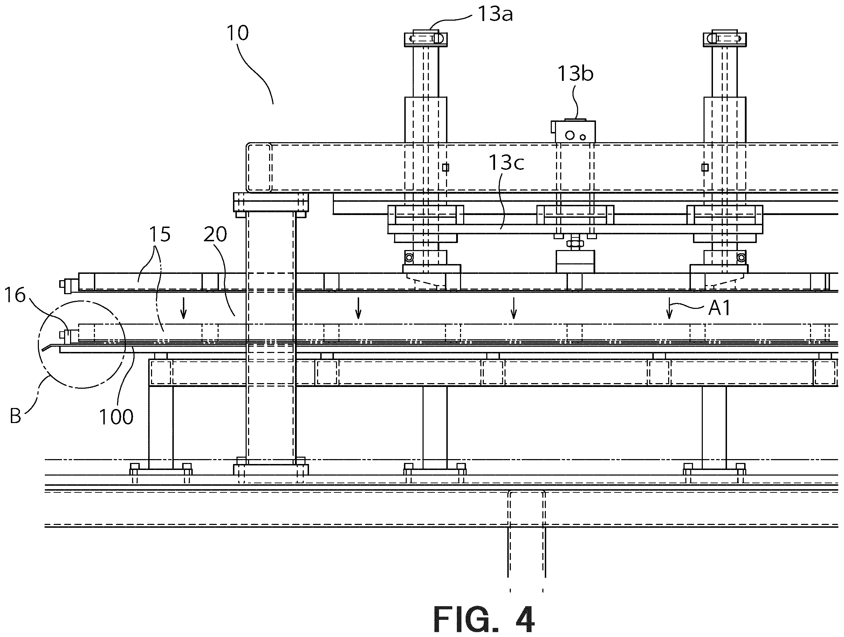

A configuration and operation of the pressing and fixing jig 11 is described in detail using Fig. 3, and Fig. 4 having an enlarged portion of the upstream side in Fig. 2.

The pressing and fixing jig 11 presses, fixes and holds, on the surface of the glass substrate 101, the solar cell module 100 which is conveyed and carried in to the predetermined position on the slide surface plate 22 of the conveying unit 20 from the upstream and which can also include a glass substrate 101 that has been accidentally broken at a power plant or the like before the carrying-in.

Above the upper surface of the solar cell module 100, in the pressing and fixing jig 11, two upward and downward drive mechanism devices 13b such as motor driven screw shafts and (hydraulically and pneumatically driven) cylinders are arranged, four guide shafts 13a are arranged at four quarters around the upward and downward drive mechanism devices 13b, and it moves with the upward and downward drive mechanism devices 13b in the upward and downward direction in the figure. The upward and downward drive mechanism devices 13b and the guide shafts 13a are fixed to the holding plate 13c, and the holding plate 13c is attached to the screw shaft 24 for jig pushing and moving. The holding plate 13c moves from the upstream side to the downstream side by the screw shaft 24 for jig pushing and moving rotating with the motor 25, and consequently, the pressing and fixing jig base board 12 fixed to the holding plate 13c moves from the upstream side to the downstream side.

Even a solar cell module 100 in which the glass substrate 101 has been accidentally broken at a power generation site or the like in the stage before the carrying-in, as mentioned above, slides and moves so as to be pushed to the cutter unit 30 in the state of being pressed, fixed and held, with the pressing and fixing jig 11, on the surface of the glass substrate 101 of the solar cell module 100 placed on the upstream-side slide surface plate 22. The glass substrate 107 which the cell matrix 106 is peeled off and separated from at the cutter unit 30 slides and moves so as to be pushed to the further downstream side in the state of being pressed, fixed and held, with the pressing and fixing jig 11, onto the surface of the downstream-side slide surface plate 43 mentioned later at the downstream pushing-out and carrying-out unit 40.

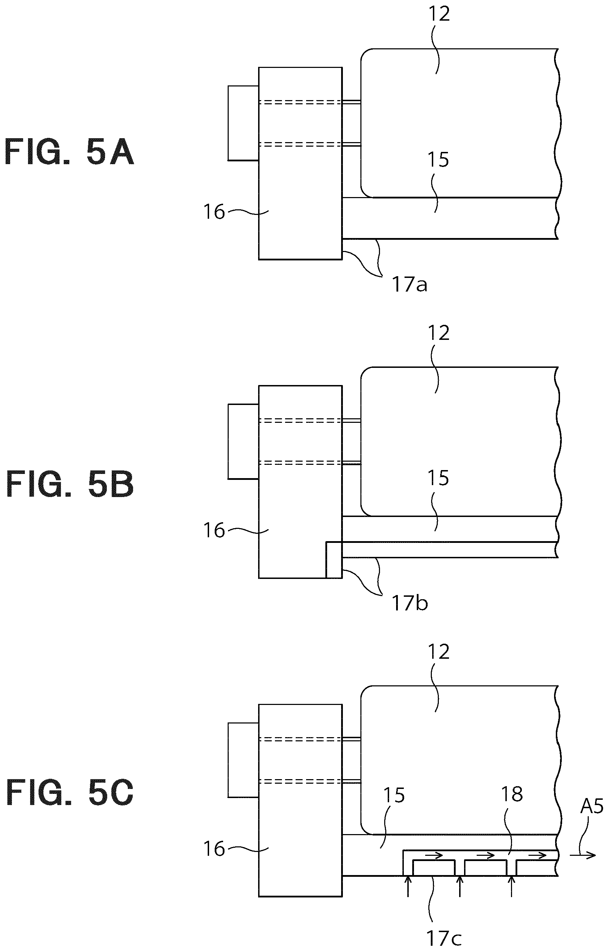

As shown in Fig. 5(a) to Fig. 5(c) each having the enlarged portion of B in Fig. 4, the pressing and fixing jig 11 has: the pressing and fixing jig base board 12 which is a structural base board material; the jig abutting base board 15 which is an abutting surface on the glass substrate 101 of the solar cell module 100; and the module end face abutting member 16 which comes into contact with the upstream-side end face of the solar cell module 100.

Herein, the surface of the jig abutting base board 15 is in the case of a metal-made abutting surface 17a which a smooth metal material is used for, for example, as shown in Fig. 5(a), in the case of a resin- or rubber-made abutting surface 17b which a hard elastomer such as resin material and hard rubber is used for as shown in Fig. 5(b), in the case of a vacuum suction abutting surface 17c, obtained by providing air piping 18 inside to open as holes on the surface, that acts as a suction surface through vacuum suction by a not-shown vacuum pump as represented by arrows as shown in Fig. 5(c), or in the similar case.

Configurations and operations of the upstream-side slide surface plate 22 and the downstream-side slide surface plate 43 are described in detail.

Structures of the upstream-side slide surface plate 22 are shown in Fig. 6(a) to Fig. 6(c) each having the enlarged portion of B in Fig. 4. Notably, the downstream-side slide surface plate 43 has the similar structure to that of the upstream-side slide surface plate 22, and its description is omitted.

The slide surface plate 22 is provided on the upper surface of the slide base board 21 which is a structural base board material, and corresponds to the abutting surface on the cell matrix 106 surface which is on the rear surface side of the glass substrate 101 of the solar cell module 100. Notably, since the cell matrix 106 has been peeled off and separated on the downstream side, the downstream-side slide surface plate 43 corresponds to the abutting surface on the rear surface side of the separated glass substrate 107.

Herein, the surface of the slide surface plate 22 is in the case of a metal-made slide surface 22a which a smooth metal material is used for, for example, as shown in Fig. 6(a), in the case of a resin-processed surface slide surface 22b which is a smooth resin material, such as Teflon(R), suitable for a slide surface or which surface resin processing is applied onto as shown in Fig. 6(b), in the case of an air film slide surface 22c, obtained by providing air piping 23 inside to open as holes on the surface, that generates an air film between those and the solar cell module 100 with air introduced and blowing by a not-shown air pump as represented by arrows A6 as shown in Fig. 6(c), or in the similar case.

A configuration and operation of the cutter unit 30 is described in detail.

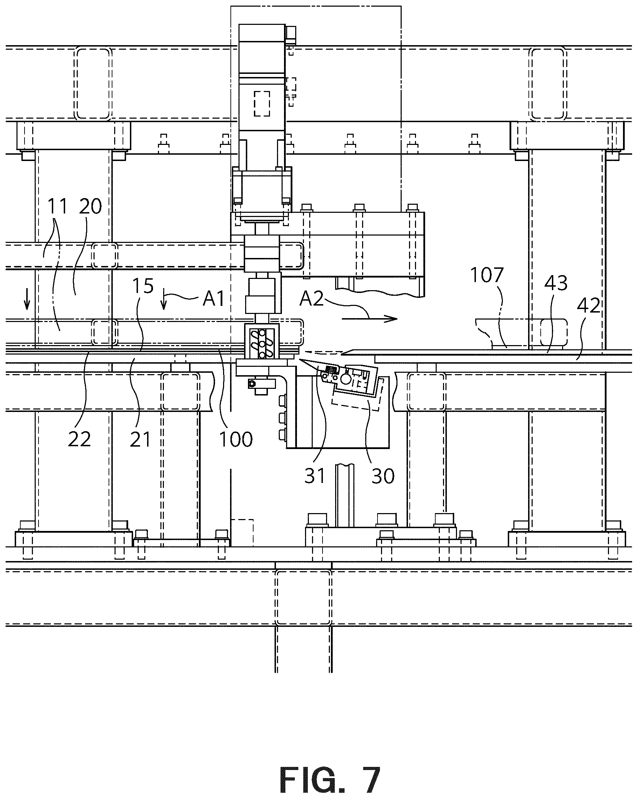

As shown in Fig. 7, the cutter unit 30 is arranged between the pressing and fixing jig 11 and the downstream pushing-out and carrying-out unit 40, and as mentioned above, the blade 31 is used as a cutting tool.

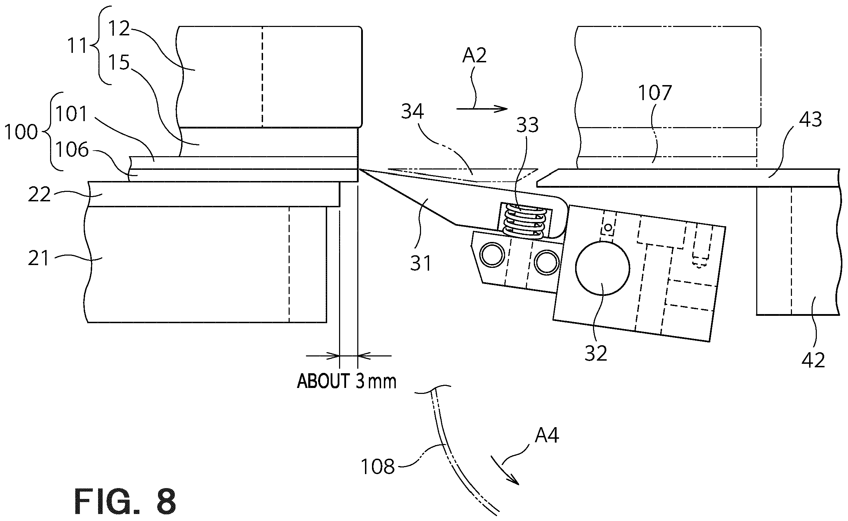

As shown in Fig. 8, the blade 31 is arranged such that its edge comes, in the order of millimeters in the horizontal direction, into contact between the glass substrate 101 and the cell matrix 106 of the solar cell module 100 which is placed on the slide surface plate 22 of the upstream-side slide base board 21, is pressed and fixed by the pressing and fixing jig 11, and is pushed to the downstream side on the slide surface plate 22.

Here, the cutter unit 30 includes an upward and downward drive mechanism which moves the blade 31 in the upward and downward direction in the figure. Moreover, although the position of the blade 31 in the horizontal direction in the figure is basically fixed, it needs to be moved by a distance required for adjustment manually or automatically with a horizontal drive mechanism in the horizontal direction. Therefore, the cutter unit 30 includes an adjustment mechanism of the attachment position of the blade 31.

Notably, as to the abutting position where the edge of the blade 31 comes into contact between the glass substrate 101 and the cell matrix 106, that is, the starting position of cutting-into, the blade 31 may be arranged by a predetermined distance from the downstream-side end face of the slide surface plate 22, for example, a predetermined distance in the order of millimeters so as to be at about 3 mm on the downstream side also in consideration of the case where the glass substrate 101 is broken.

Moreover, as shown in the figure, an auxiliary slide guide 34 may be provided between the upstream-side slide surface plate 22 and the downstream-side slide surface plate 43 such that the separated glass substrate 107 smoothly moves onto the downstream-side slide surface plate 43.

The blade 31 which is arranged as above and the edge of which is heated by the built-in heater 32 is cutting into between the glass substrate 101 and the cell matrix 106 to peel off and separate the glass substrate 101 solely, which is pushed to the downstream side so as to slide on the slide surface plate 43 of the downstream-side slide base board 42 still in the state of being fixed and held with the pressing and fixing jig 11.

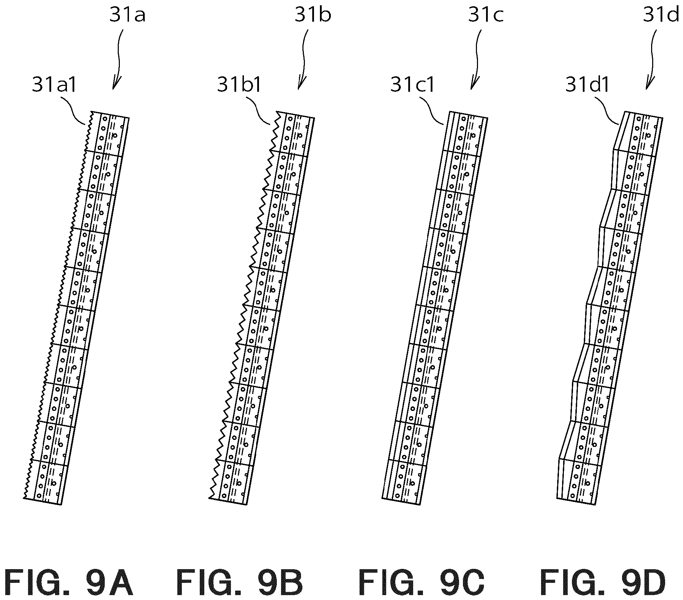

Like a blade 31a, 31b, 31c, 31d shown as an example in each of Fig. 9(a) to Fig. 9(d), the blade 31 may have a divided plurality of divided blades 31a1, 31b1, 31cl, 31d1. It may further include buffer mechanisms 33 individually provided for each of the divided blades 31a1, 31b1, 31cl, 31d1, or a buffer mechanism 33 may be included with respect to one undivided blade.

Providing such buffer mechanism(s) 33 makes it possible for the edge(s) of the one blade 31 or the divided plurality of divided blades 31a1, 31b1, 31cl, 31d1 to pivot independently with viscosity and attenuating ability and to respond to properties of the individual portions of the solar cell module 100, such as a warp thereof, and this makes it possible to make peeling-off efficiently and reliably in a short time.

This makes it possible to handle the solar cell module 100 flexibly which has every different property or every different width between its portions due to the influence of breakage of the glass substrate 101 of the solar cell module 100 or the similar influence.

While an embodiment of the present invention has been described, this embodiment is presented as an example and it is not intended to limit the technical scope of the invention. It is possible for this novel embodiment to be carried out in other various modes and various omissions, replacements and alterations may occur without departing from the spirit of the invention. Further, this embodiment and its modifications are included in the scope and spirit of the invention and included in the invention as disclosed in the claims and its equivalents.

For example, while in the aforementioned embodiment, the cutter unit 30 employs the blade as the cutting tool, it is not limited to the blade but may employ a rotary blade or the like, for example.
- 1: Recycling apparatus for a solar cell module
- 10: Pressing and fixing unit
- 11: Pressing and fixing jig
- 12: Pressing and fixing jig base board
- 13a: Guide shaft
- 13b: Upward and downward drive mechanism device
- 13c: Holding plate
- 15: Jig abutting base board
- 16: Module end face abutting member
- 17a: Metal-made abutting surface
- 17b: Resin- or rubber-made abutting surface
- 17c: Vacuum suction abutting surface
- 18, 23: Air piping
- 20: Conveying unit
- 21: Slide base board
- 22: Slide surface plate
- 22a: Metal-made slide surface
- 22b: Resin-processed surface slide surface
- 22c: Air film slide surface
- 24: Screw shaft for jig pushing and moving
- 25: Motor
- 30: Cutter unit
- 31: Blade
- 32: Heater
- 33: Buffer mechanism
- 34: Auxiliary slide guide
- 40: Downstream pushing-out and carrying-out unit
- 42: Slide base board
- 43: Slide surface plate
- 50: Carrier
- 51: Roller 51
- 52: Conveying belt
- 60: Controlling unit
- 100: Solar cell module
- 101: Glass substrate
- 102: Solar cell
- 103: Line material
- 104: Sealing agent
- 105: Back sheet
- 106: Cell matrix
- 107: Separated glass substrate
- 108: Separated cell matrix sheet

## Claims

1. A recycling apparatus for a solar cell module which separates a glass substrate and another material in a solar cell module from each other, the apparatus comprising:
a pressing and fixing unit that has a pressing and fixing jig and a conveying unit including a slide surface plate and that, given the solar cell module, pushes and conveys the solar cell module so as to slide on the slide surface plate to a downstream side by moving the pressing and fixing jig to the downstream side in a state of pressing, fixing and holding the solar cell module on the slide surface plate with the pressing and fixing jig;
a cutter unit that, with respect to the solar cell module having been conveyed by the pressing and fixing unit, separates the glass substrate and the other material from each other using a cutting tool;
a downstream pushing-out and carrying-out unit that, given the other material and the separated glass substrate, conveys them to the downstream side in a state of pressing, fixing and holding them with the pressing and fixing jig; and
a controlling unit that controls individual operations of the pressing and fixing unit, the cutter unit and the downstream pushing-out and carrying-out unit, wherein
the pressing and fixing jig has a pressing and fixing jig base board that moves upward and downward with an upward and downward drive mechanism, and a module end face abutting member, and presses, fixes and holds a surface of the solar cell module on the slide surface plate with the pressing and fixing jig base board in a state of bringing an upstream-side end face of the solar cell module into contact with itself with the module end face abutting member.

2. The recycling apparatus for a solar cell module according to Claim 1, wherein the conveying unit has a screw shaft for jig pushing and moving which the pressing and fixing jig is attached to and moves the pressing and fixing jig to the downstream side with rotation of the screw shaft for jig pushing and moving.

3. The recycling apparatus for a solar cell module according to Claim 1, wherein a surface of a jig abutting base board included in the pressing and fixing jig is any one of a metal-made abutting surface which a metal material is used for, a resin- or rubber-made abutting surface which resin or rubber is used for, and a vacuum suction abutting surface, obtained by providing air piping inside the jig abutting base board to open as holes on the surface, that acts as a suction surface through vacuum suction.

4. The recycling apparatus for a solar cell module according to Claim 1, wherein a surface of the slide surface plate is any one of a metal-made slide surface which a metal material is used for, a resin-processed surface slide surface which surface resin processing is applied onto, and an air film slide surface, obtained by providing air piping inside the slide surface plate to open as holes on the surface, that generates an air film between those and the solar cell module through air introduction.

5. The recycling apparatus for a solar cell module according to any one of Claims 1 to 4, wherein the cutter unit has a blade as the cutting tool, the blade including a plurality of divided blades, and further includes a buffer mechanism independently provided for each of the divided blades.

6. The recycling apparatus for a solar cell module according to Claim 5, the blade of the cutter unit is arranged such that an edge of the blade is positioned by a predetermined distance on a downstream side from a downstream-side end face of the slide surface plate.
